# EUROPEAN PATENT APPLICATION

(11) **EP 2 843 719 A2**
(43) Date of publication of application: **04.03.2015**
(21) Application number: 14156814.7
(22) Date of filing: 26.02.2014
(51) Int. Cl.: H01L 33/64

(54) **Light emitting device**

(30) Priority: 30.08.2013 JP 2013180680
(71) Applicant: Toshiba Lighting & Technology Corporation, Yokosuka-shi Kanagawa 237-8510 (JP)
(72) Inventor: Sasaki, Akihiro, Yokosuka-shi, Kanagawa 237-8510 (JP); Matsumoto, Katsuhisa, Yokosuka-shi, Kanagawa 237-8510 (JP); Betsuda, Nobuhiko, Yokosuka-shi, Kanagawa 237-8510 (JP)
(74) Representative: Bokinge, Ole

(57) **Abstract**

According to an embodiment, a light emitting device (110, 110a, 110b, 110c, 110d) includes a heat radiation plate (51), a semiconductor light emitting element (20), a mounting substrate section (15) including a ceramic substrate (10), and first and second metal layers (11,12), and a bonding layer (52). The ceramic substrate (10) is provided between the heat radiation plate (51) and the semiconductor light emitting element (20). The mounting substrate section (15) contacts the ceramic substrate (10) between the heat radiation plate (51) and the ceramic substrate (10), and includes a first surface (12b) on a side of the heat radiation plate (51) and a side surface (12c) intersecting a plane perpendicular to a direction from the heat radiation plate (51) to the semiconductor light emitting element (20). The bonding layer (52) is provided between the heat radiation plate (51) and the second metal layer (12), and bonds the heat radiation plate (51) and the second metal layer (12) so as to cover the first surface (12b) and to contact a part of the side surface (12b).

## Description

### FIELD

Embodiments described herein relate generally to a light emitting device.

### BACKGROUND

For example, there is a light emitting device (Chip On Board) in which a semiconductor light emitting element is mounted on a substrate and which is sealed by resin. In such a light emitting device, it is preferable that reliability be improved.

### BRIEF DESCRIPTION OF THE DRAWINGS

FIG. 1A to FIG. 1C are schematic views illustrating a light emitting device and a lighting device according to a first embodiment;
FIG. 2A and FIG. 2B are schematic cross-sectional views illustrating the light emitting device according to the first embodiment;
FIG. 3A and FIG. 3B are schematic cross-sectional views illustrating a light emitting device according to a second embodiment;
FIG. 4 is a schematic cross-sectional view illustrating the light emitting device according to the second embodiment; and
FIG. 5A and FIG. 5B are schematic cross-sectional views illustrating a light emitting device according to a third embodiment.

### DETAILED DESCRIPTION

Various embodiments will be described hereinafter with reference to the accompanying drawings.

Moreover, the drawings are schematic or conceptual and a relationship between a thickness and a width of each portion, a ratio of a size between portions, or the like is not necessarily limited to the same as that in reality. Further, even if the same portions are indicated in drawings, dimensions or ratios thereof may be indicated differently from each other depending on the drawings.

Moreover, in the specification and each view of the application, the same reference numerals are given to similar elements described already with respect to the foregoing drawings and detailed description is appropriately omitted.

### First Embodiment

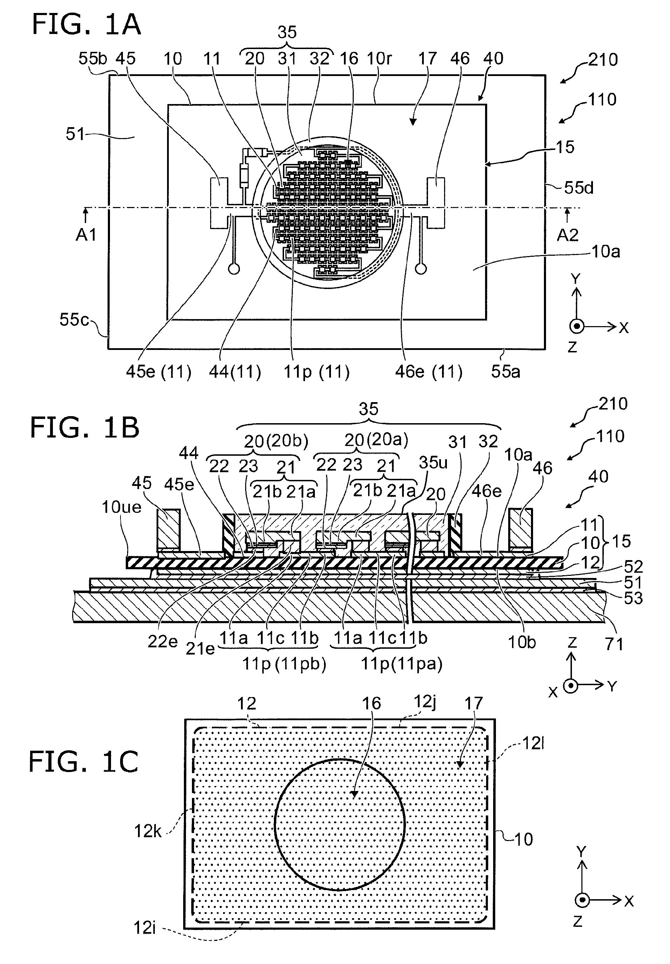

FIG. 1A to FIG. 1C are schematic views illustrating a light emitting device and a lighting device according to a first embodiment.

FIG. 1A is a plan view. FIG. 1B is a cross-sectional view illustrating a part of a cross-section along line A1-A2 of FIG. 1A.

As shown in FIG. 1A and FIG. 1B, a light emitting device 110 according to the embodiment includes a base member 71, a grease layer 53, a heat radiation plate 51, a bonding layer 52, a mounting substrate section 15 and a plurality of semiconductor light emitting elements 20. The light emitting device 110 is, for example, utilized in a lighting device 210.

A direction from the base member 71 to the mounting substrate section 15 is referred to as a laminating direction (a Z-axis direction). One direction perpendicular to the Z-axis direction is referred to as an X-axis direction. A direction perpendicular to the Z-axis direction and the X-axis direction is referred to as a Y-axis direction.

The grease layer 53, the heat radiation plate 51, the bonding layer 52, the mounting substrate section 15 and the plurality of semiconductor light emitting elements 20 are disposed on the base member 71 in this order.

That is, the plurality of semiconductor light emitting elements 20 are separated from the base member 71 in the Z-axis direction. The mounting substrate section 15 includes a ceramic substrate 10. The ceramic substrate 10 has an upper surface 10ue. For the ceramic substrate 10, for example, a member formed of ceramic, a composite ceramic of ceramic and resin or the like is used. For the ceramic, for example, aluminum oxide (Al₂O₃), aluminum nitride (AlN), beryllium oxide (BeO), steatite (MgO·SiO₂), zircon (ZrSiO₄), silicon nitride (Si₃N₄), or the like is used. The ceramic substrate 10 is provided between the base member 71 and the plurality of semiconductor light emitting elements 20. The heat radiation plate 51 is provided between the base member 71 and the mounting substrate section 15.

As illustrated in FIG. 1B, the bonding layer 52 is provided between the mounting substrate section 15 and the heat radiation plate 51. The bonding layer 52 bonds the mounting substrate section 15 to the heat radiation plate 51.

The grease layer 53 is provided between the base member 71 and the heat radiation plate 51. The grease layer 53 transmits heat of the heat radiation plate 51 to the base member 71.

Hereinafter, an example of the light emitting device 110 (and the lighting device 210) shown in FIG. 1A and FIG. 1B is described.

A light emitting section 40 is provided in the light emitting device 110. The light emitting section 40 is provided on the heat radiation plate 51. The bonding layer 52 is provided between the heat radiation plate 51 and the light emitting section 40.

In the specification of the application, a state which is provided above also includes a state in which another element is inserted therebetween, in addition to the state which is provided above directly.

A direction from the heat radiation plate 51 to the light emitting section 40 corresponds to the laminating direction. In the specification of the application, a state of being laminated also includes a state in which another element is inserted and overlapped in addition to a state of being overlapped directly.

The heat radiation plate 51 is, for example, a plate shape. A main surface of the heat radiation plate 51 is, for example, substantially parallel to an X-Y plane. A planar shape of the heat radiation plate 51 is, for example, rectangular. The heat radiation plate 51 has, for example, first to fourth sides 55a to 55d. The second side 55b is separated from the first side 55a. The third side 55c connects an end of the first side 55a and an end of the second side 55b. The fourth side 55d is separated from the third side 55c and connects the other end of the first side 55a and the other end of the second side 55b. A plate-shaped corner section of the heat radiation plate 51 may be a curved shape. The plate shape of the heat radiation plate 51 may not be rectangular and is optional.

For the heat radiation plate 51, for example, a substrate made of a metal material of copper, aluminum or the like, a composite material of metal and ceramic, or the like is used. Another metal layer such as Ni plating may be formed on a surface of the heat radiation plate 51, from the viewpoint of preventing oxidation of the member and improving wettability of a solder.

The light emitting section 40 emits light. At the same time, the light emitting section 40 generates heat. The bonding layer 52 efficiently conducts the heat generated in the light emitting section 40 to the heat radiation plate 51. For the bonding layer 52, for example, the solder or the like is used. That is, the bonding layer 52 includes the solder. For example, for the bonding layer 52, the solder including at least one kind or more of gold, silver, copper, bismuth, nickel, indium, zinc, antimony, germanium and silicon in a base of tin can be used. For example, SnAgCu alloy or the like is used.

The light emitting section 40 includes the mounting substrate section 15 and a light emitting element section 35.

The mounting substrate section 15 includes the ceramic substrate 10, a first metal layer 11 and a second metal layer 12.

The ceramic substrate 10 has a first main surface 10a and a second main surface 10b. The second main surface 10b is a surface on the side opposite the first main surface 10a. The heat radiation plate 51 faces the second main surface of the ceramic substrate 10. In other words, the second main surface 10b is a surface on the side of the heat radiation plate 51. That is, the second main surface 10b is a surface on the side of the bonding layer 52.

In the specification of the application, a facing state also includes a state where another element is inserted therebetween, in addition to a state of facing directly.

The first main surface 10a includes a mounting region 16. For example, the mounting region 16 is separated from an outer edge 10r of the first main surface 10a. In the example, the mounting region 16 is provided in a center portion of the first main surface 10a. The first main surface 10a further includes a peripheral region 17. The peripheral region 17 is provided around the mounting region 16.

The ceramic substrate 10 includes, for example, alumina. For the ceramic substrate 10, for example, a ceramic mainly composed of alumina is used. High thermal conductivity and a high insulating property can be obtained. High reliability can be obtained.

The first metal layer 11 is provided on the first main surface 10a. The first metal layer 11 includes a plurality of mounting patterns 11p. The plurality of mounting patterns 11p are provided in the mounting region 16. At least two or more of the plurality of mounting patterns 11p are separated from each other. For example, at least one of the plurality of mounting patterns 11p is an island shape. Two of the plurality of mounting patterns 11p are independent to each other. The plurality of mounting patterns 11p include, for example, a first mounting pattern 11pa and a second mounting pattern 11pb or the like.

Each of the plurality of mounting patterns 11p includes, for example, a first mounting portion 11a and a second mounting portion 11b. In the example, the mounting pattern 11p further includes a third mounting portion 11c. The third mounting portion 11c is provided between the first mounting portion 11a and the second mounting portion 11b, and connects the first mounting portion 11a and the second mounting portion 11b. Examples of the mounting portions are described below.

The first metal layer 11 may further include a connection section 44 connecting the plurality of mounting patterns 11p to each other. In the example, the first metal layer 11 further includes a first connector electrode section 45e and a second connector electrode section 46e. The first connector electrode section 45e is electrically connected to one of the plurality of mounting patterns 11p. The second connector electrode section 46e is electrically connected to another which is different from the one of the plurality of mounting patterns 11p. For example, the semiconductor light emitting element 20 is disposed on a part of one mounting pattern 11p. The first connector electrode section 45e is electrically connected to one of the mounting patterns 11p by the semiconductor light emitting element 20. Further, the semiconductor light emitting element 20 is disposed on a part of another mounting pattern 11p. The second connector electrode section 46e is electrically connected to another mounting pattern 11p by the semiconductor light emitting element 20.

In the example, the light emitting section 40 further includes a first connector 45 and a second connector 46 provided on the first main surface 10a. The first connector 45 is electrically connected to the first connector electrode section 45e. The second connector 46 is electrically connected to the second connector electrode section 46e. In the example, the first connector 45 is provided on the first connector electrode section 45e. The second connector 46 is provided on the second connector electrode section 46e. The light emitting element section 35 is disposed between the first connector 45 and the second connector 46. Power is supplied to the light emitting section 40 through the connectors.

The second metal layer 12 is provided on the second main surface 10b. The second metal layer 12 is electrically insulated from the first metal layer 11. At least of a part of the second metal layer 12 overlaps the mounting region 16 when projecting in the X-Y plane (a first plane parallel to the first main surface 10a).

FIG. 1C is a perspective plan view illustrating a part of the light emitting device 110.

The second metal layer 12 is separated from the outer edge 10r. A planar shape of the second metal layer 12 is, for example, rectangular. The second metal layer 12 has first to fourth sides 12i to 121. The second side 12j is separated from the first side 12i. The third side 12k connects an end of the first side 12i and an end of the second side 12j. The fourth side 121 is separated from the third side 12k and connects the other end of the first side 12i and the other end of the second side 12j. An intersecting point of each side, that is, a corner section may be a curved shape (a rounded shape). The planar shape of the second metal layer 12 may not be rectangular and is optional.

As described above, the first metal layer 11 is provided on the upper surface (the first main surface 10a) of the ceramic substrate 10 and the second metal layer 12 is provided on a lower surface (the second main surface 10b) of the ceramic substrate 10.

The light emitting element section 35 is provided on the first main surface 10a of the ceramic substrate 10. The light emitting element section 35 includes the plurality of semiconductor light emitting elements 20 and a wavelength conversion layer 31.

In the example, the plurality of semiconductor light emitting elements 20 are disposed in an array shape. The semiconductor light emitting elements 20 are, for example, disposed in a substantially circular shape. For example, the semiconductor light emitting elements 20 are disposed in a substantially equal pitch.

The plurality of semiconductor light emitting elements 20 are provided on the first main surface 10a. Each of the plurality of semiconductor light emitting elements 20 emits the light. For example, the semiconductor light emitting element 20 includes a nitride semiconductor. The semiconductor light emitting element 20 includes, for example, In_{y}Al_{z}Ga_{1-x-y}N (0≤x≤1, 0≤y≤1, x+y≤1). However, in the embodiment, the semiconductor light emitting element 20 is not limited to this.

The plurality of semiconductor light emitting elements 20 include, for example, a first semiconductor light emitting element 20a, a second semiconductor light emitting element 20b, or the like.

Each of the plurality of semiconductor light emitting elements 20 is electrically connected to one mounting pattern 11p in the plurality of mounting patterns 11p and to another which is adjacent to the one mounting pattern 11p in the plurality of mounting patterns 11p.

For example, the first semiconductor light emitting element 20a is electrically connected to the first mounting pattern 11pa and the second mounting pattern 11pb in the plurality of mounting patterns 11p. The second mounting pattern 11pb is equivalent to another mounting pattern 11p which is adjacent to the first mounting pattern 11pa.

For example, each of the plurality of semiconductor light emitting elements 20 includes a first semiconductor layer 21 of a first conductive type, a second semiconductor layer 22 of a second conductive type and a light emitting layer 23. For example, the first conductive type is an n-type and the second conductive type is a p-type. The first conductive type may be the p-type and the second conductive type may be the n-type.

The first semiconductor layer 21 includes a first portion (a first semiconductor portion 21a) and a second portion (a second semiconductor portion 21b). The second semiconductor portion 21b lines up with the first semiconductor portion 21a in a direction (for example, the X-axis direction) intersecting the laminating direction (the Z-axis direction that faces from the heat radiation plate 51 to the light emitting section 40).

The second semiconductor layer 22 is provided between the second semiconductor portion 21b and the mounting substrate section 15. The light emitting layer 23 is provided between the second semiconductor portion 21b and the second semiconductor layer 22.

The semiconductor light emitting element 20 is, for example, a flip-chip type LED.

For example, the first semiconductor portion 21a of the first semiconductor layer 21 faces the first mounting portion 11a of the mounting pattern 11p. The second semiconductor layer 22 faces the second mounting portion 11b of the mounting pattern 11p. The first semiconductor portion 21a of the first semiconductor layer 21 is electrically connected to the mounting pattern 11p. The second semiconductor layer 22 is electrically connected to another mounting pattern 11p. For the connection, for example, the solder, or a gold bump having high electric conductivity and thermal conductivity, or the like is used. The connection is, for example, performed by a metal melting solder bonding. Otherwise, for example, the connection is performed by an ultrasonic thermo-compression bonding method using the gold bump.

That is, for example, the light emitting element section 35 further includes a first bonding metal member 21e and a second bonding metal member 22e. The first bonding metal member 21e is provided between the first semiconductor portion 21a and one mounting pattern 11p (for example, the first mounting portion 11a). The second bonding metal member 22e is provided between the second semiconductor layer 22 and another mounting pattern 11p (for example, the second mounting pattern 11pb). At least one of the first bonding metal member 21e and the second bonding metal member 22e includes the solder or the gold bump. Therefore, each cross-sectional area (a cross-sectional area when cutting in the X-Y plane) of the first bonding metal member 21e and the second bonding metal member 22e can be increased. Therefore, heat can be efficiently transmitted to the mounting substrate section 15 and heat radiation is improved through the first bonding metal member 21e and the second bonding metal member 22e.

For example, another metal layer may be provided between the semiconductor light emitting element 20 and the mounting substrate section 15. Therefore, oxidation of the first metal layer can be suppressed or wettability of the solder can be enhanced. The metal layer is not electrically connected to the semiconductor light emitting element 20 and the mounting pattern 11p. The metal layer is not related to a circuit.

The wavelength conversion layer 31 covers at least a part of the plurality of semiconductor light emitting elements 20. The wavelength conversion layer 31 absorbs at least a part of the light (for example, a first light) emitted from the plurality of semiconductor light emitting elements 20, and emits a second light. A wavelength (for example, a peak wavelength) of the second light is different from a wavelength (for example, a peak wavelength) of the first light. For example, the wavelength conversion layer 31 includes a plurality of wavelength conversion particles such as fluorescent body and a light-transmitting resin in which the plurality of wavelength conversion particles are dispersed. The first light includes, for example, blue light. The second light includes light of which the wavelength is longer than that of the first light. For example, the second light includes at least one of yellow light and red light.

In the example, the light emitting element section 35 further includes a reflecting layer 32. The reflecting layer 32 surrounds the wavelength conversion layer 31 inside the X-Y plane. The reflecting layer 32 includes, for example, a plurality of particles such as a metal oxide and a light transmitting resin in which the particles are dispersed. The particles such as the metal oxide have light reflective properties. For the metal oxide or the like, for example, at least one of TiO₂ and Al₂O₃ can be used. The light emitted from the semiconductor light emitting element 20 can be efficiently emitted along a direction (for example, an upward direction) along the laminating direction by providing the reflecting layer 32.

The light emitting section 40 is, for example, a chip-on board (COB) type LED module.

In the embodiment, a luminous emittance of light emitted from the light emitting element section 35 (the plurality of semiconductor light emitting elements 20) is 10 lm/mm² (lumens/square millimeter) or more and 100 lm/mm² or less. Preferably, the luminous emittance is 20 lm/mm² or more. That is, in the embodiment, a ratio (the luminous emittance) for the light emitted from the light emitting element section 35 with respect to a light-emitting area is very high. In the specification of the application, the light-emitting area substantially corresponds to an area of the mounting region 16.

For example, the light emitting device 110 according to the embodiment is used in the lighting device 210 such as a projector.

For the grease layer 53, lubricant (grease) of liquid or solid, or the like is used. For the grease layer 53, for example, lubricant (insulating grease) having an insulating property, lubricant (conductive grease) having conductivity or the like is also used. The insulating grease includes, for example, silicone and ceramic particles which are dispersed in the silicone. The conductive grease includes, for example, silicone and metal particles which are dispersed in the silicone. In the conductive grease, for example, the thermal conductivity that is higher than that of the insulating grease is obtained. For example, heat of the light emitting element section 35 is transmitted and radiated to the base member 71 by the grease layer 53.

In the light emitting device 110 according to the embodiment, for example, the heat radiation plate 51 has an area of 5 times or more an area of the mounting region 16 when the heat radiation plate 51 is projected in the X-Y plane. That is, in the embodiment, the area of the heat radiation plate 51 is set to be a lot greater than that of the mounting region 16. Therefore, the heat generated in the light emitting element section 35 provided on the mounting region 16 spreads in an in-plane direction (an in-plane direction of the X-Y plane) by the heat radiation plate 51 having a large area. Then, the heat spread in the in-plane direction is transmitted, for example, toward the base member 71 and is efficiently radiated.

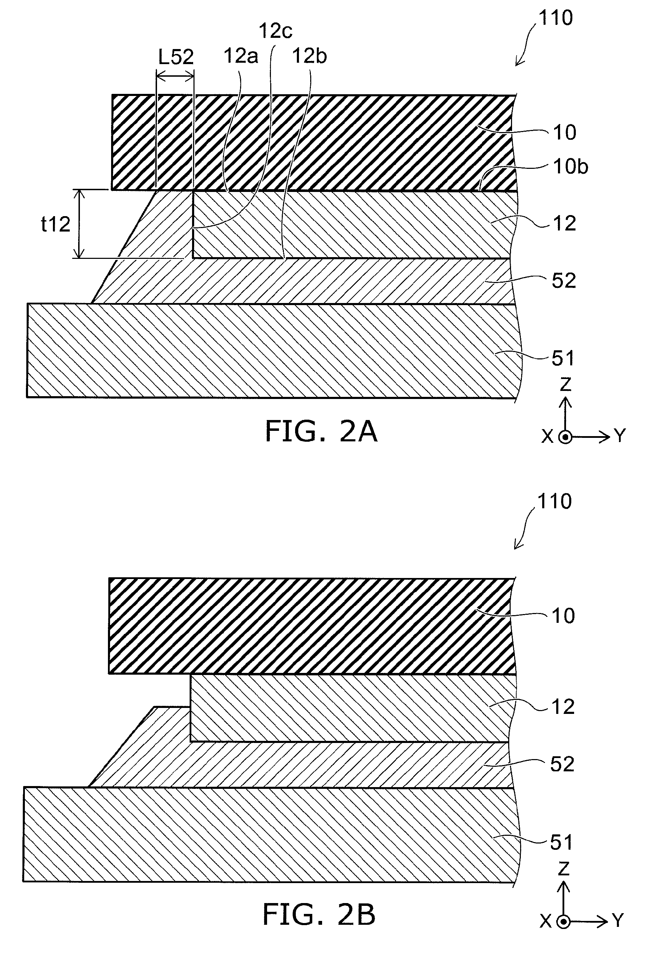

FIG. 2A and FIG. 2B are schematic views illustrating the light emitting device 110 according to the first embodiment.

FIG. 2A is a schematic cross-sectional view illustrating the vicinity of a side surface of the second metal layer 12 of the light emitting device 110 according to the first embodiment.

FIG. 2A illustrates the ceramic substrate 10 provided on the heat radiation plate 51.

As illustrated in FIG. 2A, the second metal layer 12 is provided on the lower surface (the second main surface 10b) of the ceramic substrate 10. The second metal layer 12 comes into contact with the ceramic substrate 10. The bonding layer 52 is provided between the ceramic substrate 10 and the heat radiation plate 51. The bonding layer 52 bonds the second metal layer 12 and the heat radiation plate 51.

The second metal layer 12 includes a first bonding surface 12a, a second bonding surface 12b (a first surface) and a third bonding surface 12c. The first bonding surface 12a comes into contact with the lower surface (the second main surface 10b) of the ceramic substrate 10. In order to improve adhesion of the first bonding surface 12a and the second main surface 10b, a seed layer may be provided therebetween. The second bonding surface 12b is a surface on the side opposite the first bonding surface 12a. The heat radiation plate 51 faces the second bonding surface 12b. That is, the second bonding surface 12b is a surface on the side of the heat radiation plate 51. The third bonding surface 12c intersects a surface (for example, the X-Y plane) perpendicular to a direction (for example, the Z-axis direction) facing from the first bonding surface 12a to the second bonding surface 12b. For example, the third bonding surface 12c is the side surface of the second metal layer 12.

As shown in FIG. 2A, in the example, the bonding layer 52 comes into contact with the second bonding surface 12b of the second metal layer 12. The bonding layer 52 comes into contact with the third bonding surface 12c of the second metal layer 12. The bonding layer 52 covers the second bonding surface 12b and the third bonding surface 12c

The bonding layer 52 covers the lower surface (the second bonding surface 12b) and the side surface (the third bonding surface 12c) of the second metal layer 12. The bonding layer 52 bonds the heat radiation plate 51 and the second metal layer 12. As illustrated in FIG. 2A, a part of the bonding layer 52 comes into contact with the second main surface 10b of the ceramic substrate 10.

For example, a thickness 112 of the second metal layer 12 is not less than 20 µm and not more than 300 µm. For example, in a cross-section (the Z-Y plane) perpendicular to the X-axis, a contact distance L52 between the bonding layer 52 and the second main surface 10b is, for example, not less than 3 µm and not more than 100 µm.

FIG. 2B is a schematic cross-sectional view illustrating the vicinity of the side surface of the second metal layer 12 of another light emitting device according to the first embodiment.

As shown in FIG. 2B, the bonding layer 52 may be provided so as to come into contact with a part of the side surface of the second metal layer 12. In the example, the bonding layer 52 covers the lower surface of the second metal layer 12.

The semiconductor light emitting element 20 emits the light by electrification. For example, if the semiconductor light emitting element 20 is electrified, a part of power which is consumed turns into heat. If power consumed by the semiconductor light emitting element 20 is great, the semiconductor light emitting element 20 may excessively generate heat. A light emitting efficiency of the semiconductor light emitting element 20 may be decreased by the heat generated when the semiconductor light emitting element 20 emits the light. For example, if the light emitting device using the semiconductor light emitting element 20 is mounted on the lighting device, the mounting method is devised. Therefore, heat radiation is performed.

In the light emitting device 110 according to the embodiment, the bonding layer 52 is provided between the lower surface (the second bonding surface 12b) of the second metal layer 12 and the heat radiation plate 51. Therefore, for example, the second metal layer 12 is electrically connected to the heat radiation plate 51. Therefore, the heat generated when the semiconductor light emitting element 20 emits the light is radiated. For the bonding layer 52, for example, the solder is used.

The solder may include, for example, a metal filler having high thermal conductivity. The metal filler is, for example, Ni, Cu, Al, Zn, Ag, Mg, W, Ir, Be or Mo. The solder including the metal filler may be partially used. For example, the solder including the metal filler may be used in the bonding layer 52 which is positioned below the semiconductor light emitting element 20.

As a bonding method of the heat radiation plate 51 and the second metal layer 12, for example, there is a method where grease is provided between the second metal layer 12 and the heat radiation plate 51. Grease has, for example, fluidity. When the light emitting device is lighted on and off repeatedly, the member expands and contracts repeatedly and grease may be discharged (pumped out) to the outside by the heat generated due to the light emission. If operating environments of the light emitting device are changed, pump-out occurs and reliability may decrease. In the light emitting device 110 according to the embodiment, grease is not used between the heat radiation plate 51 and the second metal layer 12. Therefore, phenomenon such as pump-out does not occur.

For example, a thermal expansion coefficient of the ceramic substrate 10 and a thermal expansion coefficient of the heat radiation plate 51 are different from each other. Therefore, cracks occur in the bonding layer 52 and reliability may be decreased. The cracks occur, for example, from an end of the bonding surface of the bonding layer 52 and the second metal layer 12 and expand in the bonding layer 52. In the light emitting device 110 according to the embodiment, the lower surface (the second bonding surface 12b) and the side surface (the third bonding surface 12c) of the second metal layer 12 are covered by the bonding layer 52. Therefore, for example, the expansion of the cracks can be delayed. Further, if a corner section of the second metal layer 12 is a rounded shape, it is further effective against the cracks.

At least a part of an entire region of the side surface of the second metal layer 12 in the light emitting device 110 may be a state as illustrated in FIG. 2A. However, in order to further improve the heat radiation properties, it is preferable that the portion be the most (80% or more of the entire region) or the entire region.

According to the embodiment, the expansion of the cracks is suppressed in the bonding layer 52 and the light emitting device having high reliability is provided.

### Second Embodiment

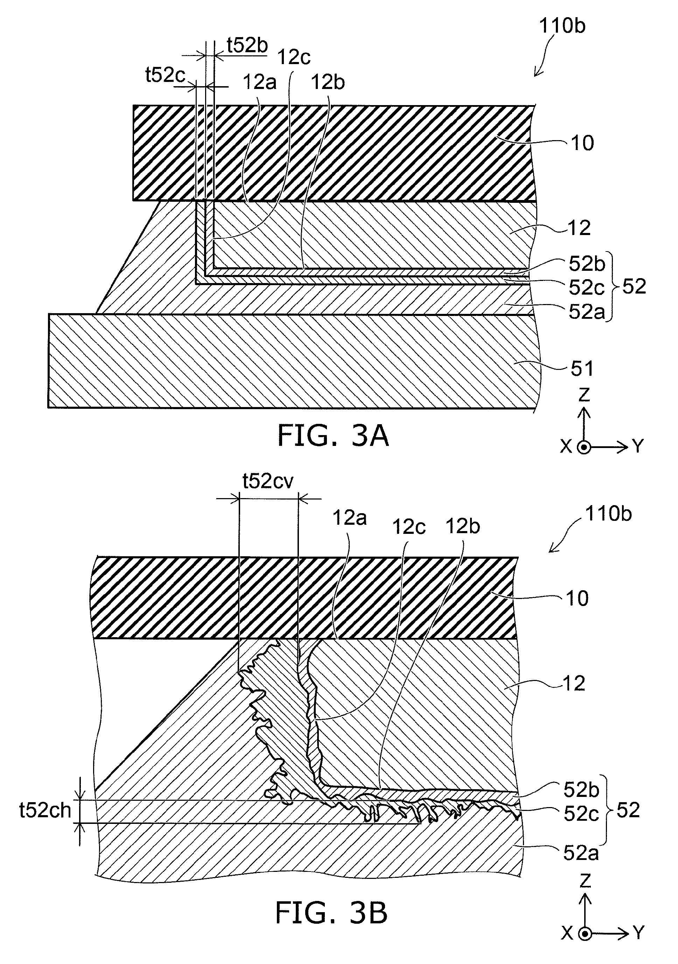

FIG. 3A and FIG. 3B are schematic cross-sectional views illustrating a light emitting device 110b according to a second embodiment.

As shown in FIG. 3A, the bonding layer 52 includes a first bonding metal film 52a, a second bonding metal film 52b and a third bonding metal film 52c. The second bonding metal film 52b is provided between the first bonding metal film 52a and the second metal layer 12. The third bonding metal film 52c is provided between the first bonding metal film 52a and the second bonding metal film 52b.

A thickness t52b of the second bonding metal film 52b is, for example, not less than 3 µm and not more than 100 µm. For the second metal layer 12, for example, Cu is used. For the bonding layer 52, for example, the solder is used. The first bonding metal film 52a includes, for example, Sn. The second bonding metal film 52b is formed of, for example, electroless plating and includes Ni, Pd, Au or the like. After the second bonding metal film 52b is formed by the electroless plating, the first bonding metal film 52a is formed by the solder and the third bonding metal film 52c is formed when the second metal layer 12 and the heat radiation plate 51 are bonded. The second bonding metal film 52b is, for example, a film including Ni, Pd and Au. The third bonding metal film 52c includes a compound of elements included in the first bonding metal film 52a and the second bonding metal film 52b, for example, a compound of Ni and Sn.

Therefore, reaction of Sn included in the first bonding metal film 52a and Cu included in the second metal layer 12 is suppressed. For example, growth of an intermetallic compound of CuSn is suppressed. Growth of the intermetallic compound of Cu and Sn is fast. The intermetallic compound is weak. If the intermetallic compound grows, breakdown is likely to occur and the cracks may occur. According to the light emitting device 110b of the embodiment, formation of the intermetallic compound of Cu and Sn is suppressed and the light emitting device having high reliability is provided by providing the second bonding metal film 52b having main elements that are less reactive compared to Cu.

The first bonding metal film 52a is, for example, the solder including Sn. The second bonding metal film 52b is a plating layer including Ni. The third bonding metal film 52c includes, for example, a NiSn alloy. For example, NiSn has slower growing speed compared to CuSn. That is, since a weak region can be reduced in a compound layer formed of a NiSn alloy layer having Sn compared to a CuSn alloy layer, the cracks are unlikely to occur. For example, a thickness t52c of the third bonding metal film 52c is 1 µm to 100 µm.

FIG. 3B is a schematic cross-sectional view of the light emitting device 110b in another Z-Y plane. In the example, the third bonding metal film 52c includes a NiSn alloy section. For example, after a plating layer including Ni is formed as the second bonding metal film 52b, the third bonding metal film 52c is formed when the first bonding metal film 52a is formed by the solder.

As shown in FIG. 3B, in the bonding layer 52 coming into contact with the third bonding surface 12c, the third bonding metal film 52c is formed in a direction from the second bonding metal film 52b to the first bonding metal film 52a. That is, in the example, the NiSn alloy section extends in a direction intersecting the side surface (the third bonding surface 12c) of the second metal layer 12. Therefore, for example, the expansion of the cracks can be suppressed.

For example, a thickness t52cv of the third bonding metal film in the side surface of the second metal layer 12 is thicker than a thickness t52ch of the third bonding metal film in the side surface of the second metal layer 12.

For example, the thickness t52ch of the third bonding metal film in the lower surface of the second metal layer 12 is not less than 1 µm and not more than 100 µm. The thickness t52cv of the third bonding metal film in the side surface of the second metal layer 12 is equal to or thicker than the thickness of the lower surface of the second metal layer 12.

According to the embodiment, the expansion of the cracks is suppressed in the bonding layer 52 and the light emitting device having high reliability is provided.

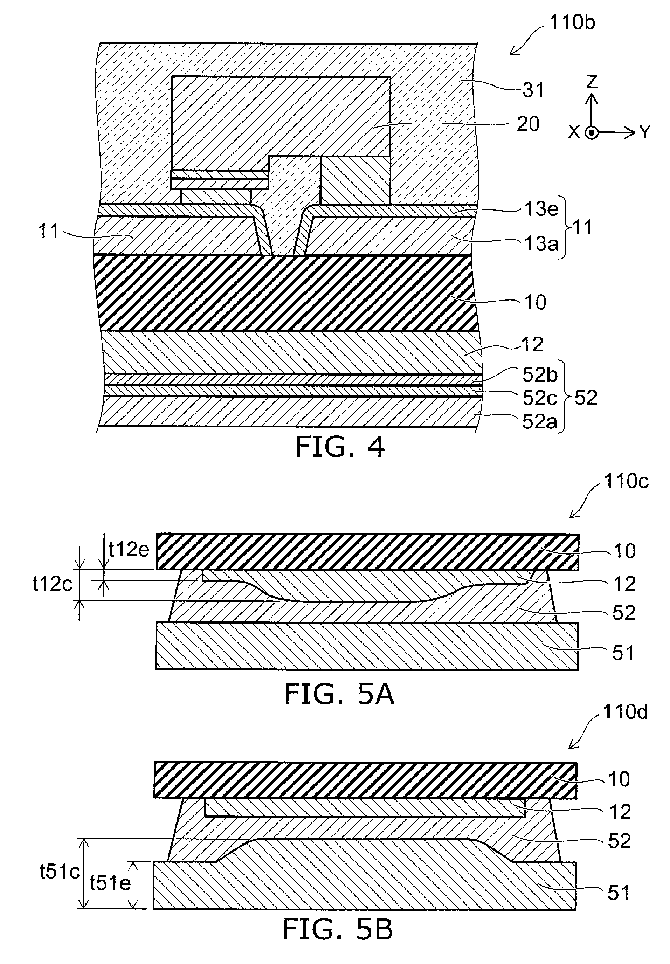

FIG. 4 is a schematic cross-sectional view illustrating the light emitting device 110b according to the second embodiment.

As shown in FIG. 4, the light emitting device 110b according to the embodiment includes the first metal layer 11. The first metal layer 11 is provided between the ceramic substrate 10 and the semiconductor light emitting element 20. The first metal layer 11 includes a copper layer 13a and a plating layer 13e. At least a part of the plating layer 13e is provided between the copper layer 13a and the semiconductor light emitting element 20. The plating layer 13e is also formed on a side surface of the copper layer 13a. The plating layer 13e is formed of, for example, the electroless plating, similar to the second bonding metal film 52b. The plating layer 13e includes, for example, Ni and Au. Ni suppresses generation of a CuSn alloy. Au suppresses absorption of the light from the semiconductor light emitting element 20 by suppressing oxidation of Ni. Since the metal layer including Ni and Au is also formed in the side surface in addition to the mounting surface of the copper layer 13a of the semiconductor light emitting element 20, the reliability of connection of the solder can be increased while increasing the light emitting efficiency. The thickness of the Au layer, that is, an amount which is used is reduced and then costs thereof can be reduced by further containing Pd in the plating layer 13e.

The plating layer 13e formed in the copper layer 13a and the second bonding metal film 52b formed in the second metal layer 12 are preferably formed in the same material and the same configuration. That is, the metal layers including Ni and Au are preferably formed on the surface and the side surface of both the copper layer 13a and the second metal layer 12. Thus, structures (manufacturing methods) and materials thereof can be made common. Therefore, the costs can be further reduced.

### Third Embodiment

FIG. 5A and FIG. 5B are schematic cross-sectional views illustrating a light emitting device according to a third embodiment.

As shown in FIG. 5A, the thickness of the second metal layer 12 of a light emitting device 110c according to the embodiment may not be uniform. In the example, a thickness t12c of the center section of the second metal layer 12 is thicker than a thickness t12e of the outer periphery section of the second metal layer 12. Therefore, for example, the heat radiation properties of the center section can be improved and the light emitting device having high reliability is provided.

As shown in FIG. 5B, the thickness of the heat radiation plate 51 of a light emitting device 110d may not be uniform. In the example, a thickness t15c of the center section of the heat radiation plate 51 is thicker than a thickness t15e of the outer periphery section of the heat radiation plate 51. Therefore, for example, the heat radiation properties of the center section can be improved and the light emitting device having high reliability is provided.

According to the embodiment, the light emitting device having high reliability is provided.

Moreover, in the specification of the application, terms of "perpendicular" and "parallel" are not only strictly perpendicular and strictly parallel but also are intended to include variation thereof or the like, for example, in a manufacturing process, and may be substantially perpendicular and substantially parallel.

Above, the embodiments are described with reference to specific examples. However, the exemplary embodiment is not limited to the specific examples. For example, specific configurations of each element such as the semiconductor light emitting element, the mounting substrate section, the heat radiation plate, the ceramic substrate, the first metal layer, the second metal layer, and the bonding layer are included within the scope of the exemplary embodiment as long as the configurations can be executed similar to the exemplary embodiment and the same effects can be obtained by those skilled in the art.

Further, it is included in the scope of the exemplary embodiment that two or more elements of each specific example are combined in a technically possible range as long as they are included within the gist of the exemplary embodiment.

In addition, in the scope of the spirit of the exemplary embodiment, those skilled in the art can conceive various modification examples and alteration examples, and it is understood that the modification examples and the alteration examples belong within the scope of the exemplary embodiment.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light emitting device (110, 110a, 110b, 110c, 110d) comprising:
a heat radiation plate (51);
a semiconductor light emitting element (20);
a mounting substrate section (15) including
a ceramic substrate (10) provided between the heat radiation plate (51) and the semiconductor light emitting element (20),
a first metal layer (11) provided between the semiconductor light emitting element (20) and the ceramic substrate (10), and
a second metal layer (12) being in contact with the ceramic substrate (10) between the heat radiation plate (51) and the ceramic substrate (10), and including a first surface (12b) on a side of the heat radiation plate (51) and a side surface (12c) intersecting a plane perpendicular to a direction from the heat radiation plate (51) to the semiconductor light emitting element (20); and
a bonding layer (52) provided between the heat radiation plate (51) and the second metal layer (12), and bonding the heat radiation plate (51) and the second metal layer (12) so as to cover the first surface (12b) and to be in contact with a part of the side surface (12c).

2. The device (110, 110a, 110b, 110c, 110d) according to claim 1,
wherein the bonding layer (52) covers an entire side surface (12c) in thickness direction.

3. The device (110, 110a, 110b, 110c, 110d) according to claim 1 or 2,
wherein a part of the bonding layer (52) is in contact with a part of a surface (10b) of the ceramic substrate (10) facing the heat radiation plate (51).

4. The device (110b) according to any one of claims 1 to 3,
wherein the bonding layer (52) further includes
a first bonding metal film (52a) including Sn,
a second bonding metal film (52b) provided between the first bonding metal film (52a) and the second metal layer (12), and covering the first surface (12b) and the side surface (12c), and including Ni, and
a third bonding metal film (52c) provided between the first bonding metal film (52a) and the second bonding metal film (52b), and including Ni and Sn.

5. The device (110b) according to claim 4,
wherein the third bonding metal film (52c) includes a NiSn alloy section extending in a direction intersecting the side surface (12c).

6. The device (110b) according to claim 4,
wherein a thickness (t52cv) of a portion of the third bonding metal film (52c) which covers the side surface (12c) is thicker than a thickness (t52ch) of a portion of the third bonding metal film (52c) which covers the first surface (12b).

7. The device (110, 110a, 110b, 110c, 110d) according to any one of claims 1 to 6,
wherein the bonding layer (52) includes at least one of Pd and Au.

8. The device (110, 110a, 110b, 110c, 110d) according to any one of claims 1 to 7,
wherein the first metal layer (11) further includes
a copper layer (13a) provided between the ceramic substrate (10) and the semiconductor light emitting element (20), and
a plating layer (13e) having at least a part provided between the copper layer (13a) and the semiconductor light emitting element (20), and including at least one of Ni, Pd and Au.
